Europäisches Patentamt

European Patent Office

Office européen des brevets

(11) Veröffentlichungsnummer: **0 022 559**
A1

(12) **EUROPÄISCHE PATENTANMELDUNG**

(21) Anmeldenummer: 80103936.3

(51) Int. Cl.³: **H 03 H 9/13**

(22) Anmeldetag: 09.07.80

(30) Priorität: 16.07.79 DE 2928669

(43) Veröffentlichungstag der Anmeldung: 21.01.81
Patentblatt 81/3

(84) Benannte Vertragsstaaten: AT BE CH DE FR GB IT LI NL SE

(71) Anmelder: SIEMENS AKTIENGESELLSCHAFT Berlin und München, Postfach 22 02 61, D-8000 München 22 (DE)

(72) Erfinder: Brauneis, Helmut, Jägerstrasse 9, D-8131 Bernried (DE)
Erfinder: Eschler, Hans, Dr., Auguste-Viktoria-Strasse 110, D-1000 Berlin 33 (DE)
Erfinder: Faist, Eugen, Elberfelder Strasse 26, D-1000 Berlin 21 (DE)
Erfinder: Strick, Günther, Pfalzburger Strasse 70, D-1000 Berlin 31 (DE)

(54) Zu Dickenscherungsschwingungen anregbarer plattenförmiger piezoelektrischer Resonator.

(57) Bei insbesondere rechteckigen oder quadratischen Resonatoren, die mit gegenüberliegenden Längsseiten in Aufnahmerillen zweier Halte- und Anschlußorgane eingesetzt werden, sind auf jeder Resonatoroberfläche (2) zwei Anschlußelektroden (8) vorgesehen und zu benachbarten Ecken des Resonators geführt, so daß der Resonator (1) in zwei um 180° verschiedenen Positionen in die Aufnahmerillen eingesetzt werden kann und dabei an den freien Enden der Aufnahmerillen kontaktierbar ist.

0022559

SIEMENS AKTIENGESELLSCHAFT          Unser Zeichen:
Berlin und München                  VPA 79 P 6 6 1 3 EUR

Zu Dickenscherungsschwingungen anregbarer plattenförmiger
piezoelektrischer Resonator

Die Erfindung bezieht sich auf einen zu Dickenscherungsschwingungen anregbaren, plattenförmigen piezoelektrischen
Resonator mit zwei auf den beiden großen Oberflächen des
Resonators angeordneten zentralen Anregungselektroden,
die einander gegenüberliegen, und mit wenigstens jeweils
einer auf jeder der großen Oberflächen des Resonators
zwischen einer Anregungselektrode und dem Resonatorrand
vorgesehenen Anschlußelektrode, wobei jeweils eine Anschlußelektrode auf der einen Seite des Resonators zu
einer Anschlußelektrode auf der anderen Seite des Resonators bezüglich einer die großen Oberflächen des Resonators halbierenden Symmetrieebene spiegelsymmetrisch
verläuft und jeweils der einer Anschlußelektrode gegenüberliegende Resonatorbereich frei von Gegenelektroden
ist, sowie mit zwei Anschlußorganen, die den Resonator
randseitig im Bereich von auf den beiden Seiten des
Resonators vorgesehenen Anschlußelektroden erfassen.

Rt 1 Sse - 16.7.1979

Bei derartigen Resonatoren, die z.B. aus der DE-AS 27 37 034 bekannt sind, ist zwischen dem Resonatorrand und einem zentralen, von den Anregungselektroden bedeckten Resonatorbereich ein elektrodenfreier Abstand vorgesehen, so daß die Schwingungen des Resonators im wesentlichen auf den Bereich der Anregungselektroden beschränkt sind und der Resonator am weitgehend schwingungsfreien Rand von Anschluß- und Halteorganen erfaßt werden kann, ohne daß durch diese Halteorgane die Schwingeigenschaften des Resonators ungünstig beeinflußt werden können. Zwischen den Anregungselektroden und den von den Anschluß- und Halteorganen des Resonators erfaßten Randbereichen des Resonators sind sogenannte Anschlußelektroden vorgesehen, die in gleicher Weise, wie die Anregungselektroden auf das Material des Resonators aufgebracht, z.B. aufgedampft sind, und durch leitende Metallschichten gebildet werden. Im Bereich der Anschlußelektroden fällt die Schwingungsamplitude zum Rand des Resonators hin exponentiell ab, da eine Gegenelektrode auf der anderen Seite des Resonators fehlt.

Bei rechteckigen oder quadratischen Resonatoren, deren Ecken auch abgerundet sein können, sind die Anschlußelektroden vorteilhaft in Richtung der Ecken des Resonators geführt, weil dadurch der Abstand zwischem dem Zentrum des Resonators und den Angriffspunkten von Anschluß- und Halteorganen am größten gemacht werden kann.

Solche vorzugsweise rechteckigen oder quadratischen Resonatoren können vorteilhaft durch einfaches Einschieben des Resonators mit zwei einander gegenüberliegenden Längsrändern in Führungsrillen von Halteorganen fixiert werden, wobei durch eine geeignete Bemessung der Führungsrillen erreicht werden kann, daß der Resonator lediglich an den Enden seiner Längsränder von den Seitenwänden der Rillen berührt wird.

Im Zuge der immer mehr zunehmenden Automatisierung von Fertigungsschritten ist man bestrebt, das Einsetzen von Resonatoren in solche Halterungsvorrichtungen von Automaten ausführen zu lassen. Damit dabei die Anschlußelektroden zu denjenigen Ecken des Resonators verlaufen, die sich an den freien Enden der Anschlußorgane befinden, denn hier wird z.B. durch Einbringen von Leitkleber eine elektrische Verbindung zwischen den Anschlußelektroden und damit den Anregungselektroden des Resonators und den aus leitendem Material bestehenden Halteorganen hergestellt, muß jeder Resonator vor dem Einsetzen in die Halteorgane in eine ganz bestimmte Position gebracht werden. Dies erfordert jedoch relativ aufwendige Einrichtungen, die in der Lage sind, den Verlauf der Anschlußelektroden auf dem Resonator zu ermitteln.

Aufgabe der Erfindung ist es daher, einen Resonator der eingangs genannten Art so weiterzubilden, daß das lagerichtige Einsetzen des Resonators in Halte- und Anschlußorgane wesentlich vereinfacht werden kann.

Erfindungsgemäß ergibt sich die Lösung dieser Aufgabe dadurch, daß auf jeder Seite des Resonators neben der zu einem elektrischen Verbindungspunkt zwischen einem Anschlußorgan und einer Anschlusselektrode verlaufenden Anschlußelektrode eine weitere/leerlaufende Anschlußelektrode vorgesehen ist, die bezüglich einer Symmetrieebene des Resonators, welche die großen Oberflächen des Resonators halbiert, spiegelsymmetrisch zu der jeweils anderen Anschlußelektrode auf derselben Oberflächenseite des Resonators angeordnet ist.

Auf diese Weise erhält man auf jeder Seite des Resonators zwei potentielle Anschlußpunkte, von denen jedoch nur einer benutzt wird, während der andere leerläuft.

Dadurch ergeben sich mindestens, zwei voneinander verschiedene, anschlußgerechte Positionen des Resonators,
mit denen der Resonator in die Anschlußorgane eingesetzt
werden kann. Die Wahrscheinlichkeit, daß bei der Entnahme eines Resonators aus einem ungeordneten Resonatorvorrat, dieser Resonator sich schon oder beinahe in anschlußgerechter Position befindet, wird dadurch wesentlich vergrößert bzw. ein solcher Resonator muß nur noch
geringfügig bewegt werden, um in eine einsteckgerechte
Position gebracht zu werden.

In weiterer Ausgestaltung der Erfindung kann noch vorgesehen sein, daß die Anschlußelektroden bei rechteckigem
oder quadratischem Umriß des Resonators zu den vier
Ecken des Resonators geführt sind.

Auf diese Weise sind die potentiellen Anschlußpunkte
des Resonators vorteilhaft am weitesten von seinem aktiven Bereich, also dem Resonatorbereich zwischen den
Anregungselektroden, entfernt. Außerdem befinden sich
die Anschlußpunkte beim Einschieben des Resonators mit
zwei einander gegenüberliegenden Längsseiten in Aufnahmerillen von Halteorganen immer an den freien Enden der
Halteorgane und sind daher leicht zugänglich. Das Einbringen von Leitkleber in die Aufnahmerillen zur Herstellung eines guten elektrischen Kontaktes zwischen den
Anschlußelektroden und den Halteorganen ist dadurch besonders einfach möglich.

Schließlich kann im Rahmen vorliegender Erfindung noch
vorgesehen sein, daß die Anschlußelektroden zwischen
den Anregungselektroden und dem Rand des Resonators mit
einer Einschnürung versehen sind.

0022559

Dadurch wird vorteilhaft die "Randempfindlichkeit" des Resonators weiter herabgesetzt, d.h. der Einfluß von am Rand des Resonators angreifenden Anschlußorganen auf das Schwingverhalten des Resonators wird weiter vermindert.

Ausführungsbeispiele der Erfindung werden nachfolgend anhand von zwölf Figuren noch näher erläutert.

Dabei zeigen, jeweils in Vorderansicht:

Fig. 1 und Fig. 2    einen in bekannter Weise mit lediglich einer Anschlußelektrode auf jeder seiner großen Oberflächen versehenen Resonator, der in zwei Anschluß- und Halteorgane eingesetzt ist,

Fig. 3    einen auf jeder seiner großen Oberflächen mit zwei Anschlußelektroden versehenen Resonator in eine Halterung eingesetzt, die entsprechend den in den Figuren 1 und 2 dargestellten ausgebildet ist,

Fig. 4    einen quadratischen Resonator, der auf jeder seiner großen Oberflächen zwei Anschlußelektroden aufweist und an zwei gegenüberliegenden Eckpunkten von Halteorganen erfaßt wird,

und die Fig. 5 bis 12    Resonatoren mit zwei auf jeder ihrer großen Oberflächen vorgesehenen Anschlußelektroden mit unterschiedlichem Umriß des Resonators bzw. unterschiedlicher Ausbildung der Anregungselektroden und/oder der Anschlußelektroden.

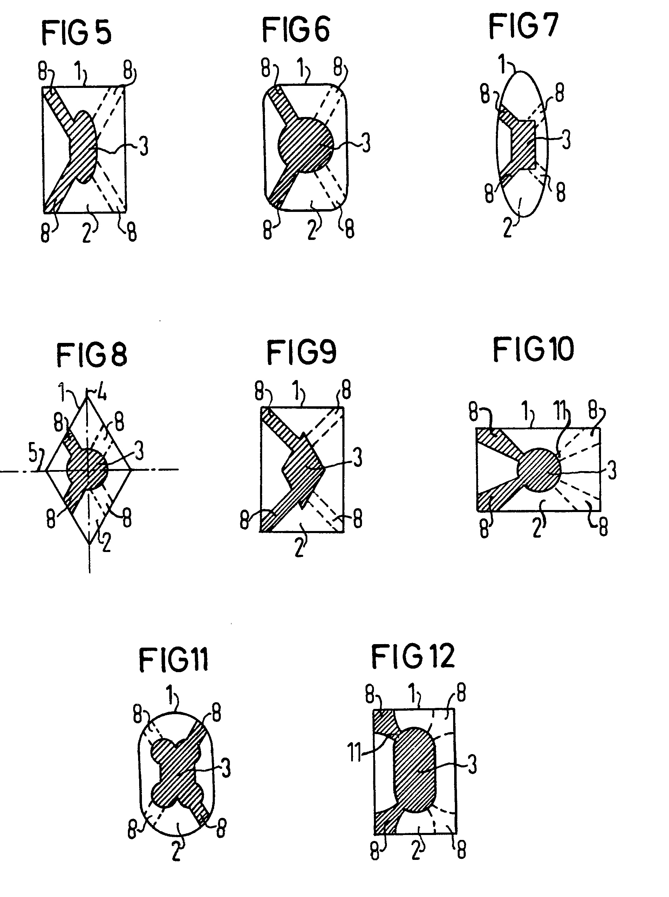

Im einzelnen ist den Figuren zu entnehmen, daß ein aus piezoelektrischem Material bestehender plattenförmiger Resonator 1, der zu Dickenscherungsschwingungen anregbar ist, auf jeder seiner beiden großen Oberflächen 2 jeweils eine zentrale Anregungelektrode 3 aufweist. Die Anregungselektroden 3 auf beiden Seiten des Resonators 1 decken sich und sind konzentrisch zum Umriß des Resonators angeordnet. Dieser Umriß kann, wie die Fig. 5 bis 12 zeigen, rechteckig, insbesondere quadratisch, aber auch rautenförmig (Fig.8) sein, (wobei die Ecken des Resonators auch abgerundet sein können (Fig. 6) ) oval (Fig. 11) oder ellipsenförmig (Fig. 7) verlaufen.

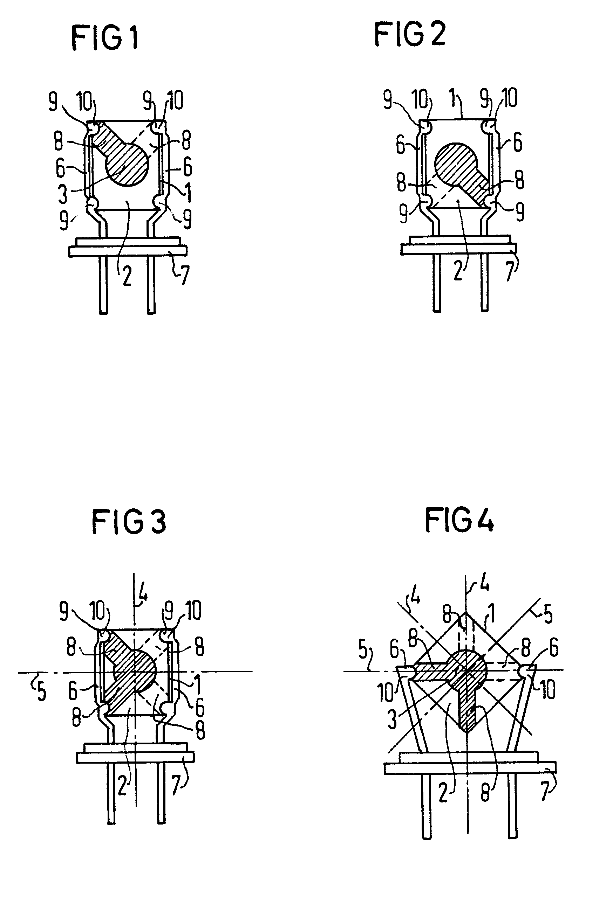

Der Resonator 1 weist jedenfalls einen Umriß auf, der so beschaffen ist, daß zwei aufeinander senkrecht stehende Symmetrieebenen 4, 5 (Fig. 3) jeweils die großen Oberflächen 2 des Resonators 1 halbieren.

Wie Fig. 4 zeigt, hat daher ein solcher Resonator wenigstens zwei Positionen, die bezüglich zweier Halteorgane 6, welche den Resonator randseitig umfassen, indem sie mit den Schenkeln einer U-förmigen Haltekontur vom Rand des Resonators 1 her auf die beiden großen Oberflächen 2 des Resonators übergreifen, geometrisch gleichwertig sind.

Die Halteorgane 6 selbst bestehen aus elektrisch leitendem Material und sind z.B. in einer Bodenplatte 7, elektrisch gegeneinander isoliert, fixiert. Die Halteorgane 6 werden daher zugleich dazu verwendet, die Anregungselektroden 3 des Resonators 1 an eine Wechselspannungsquelle anzuschließen, die mit dem Resonator zusammenwirken soll.

Bei Dickenscherungsschwingern ist der aktive Bereich des Resonators, also der Bereich, in dem dieser schwingt, im wesentlichen auf den zwischen den Anregungselektroden 3 liegenden Bereich beschränkt, so daß durch ent-

0022559

sprechende Bemessung der großen Oberflächen 2 des Resonators 1 im Verhältnis zu der Ausdehnung der Anregungselektroden 3 der Rand des Resonators, insbesondere derjenige Randbereich , an dem die Halteorgane 6 angreifen, genügend stark vom aktiven Bereich des Resonators entkoppelt werden kann. Deshalb ist es erforderlich, den Abstand zwischem dem Rand des Resonators, an dem die Halteorgane 6 angreifen und den Anregungselektroden 3 durch streifenförmige Anschlußelektroden 8 zu überbrücken. Jeweils eine Anschlußelektrode 8 auf einer der beiden großen Oberflächen 2 des Resonators 1 ist dabei so geführt, daß sie bezüglich einer Symmetrieebene 4 des Resonators spiegelbildlich zu einer Anschlußelektrode 8 auf der anderen großen Oberfläche des Resonators verläuft. So sind z.B. bei dem quadratischen Resonator entsprechend Fig. 4 zwei Anschlußelektroden 8 zu zwei einander gegenüberliegenden Ecken des Resonators geführt und die Halteorgane 6 erfassen den Resonator 1 in jeweils einer dieser Ecken. Zwei weitere Anschlußelektroden 8 sind auf jeder Seite des Resonators so vorgesehen, daß sie bezüglich einer die großen Oberflächen des Resonators 1 halbierenden Symmetrieebene 5 zu der jeweils anderen Anschlußelektrode 8 auf derselben Seite des Resonators spiegelsymmetrisch verlaufen. Dies hat bei dem in Fig. 4 dargestellten Resonator 1 zur Folge, daß die beiden anderen Anschlußelektroden zu den jeweils anderen Ecken des Resonators gerichtet sind. Da sich im Bereich der Anschlußelektroden 8 keine Schwingungen ausbilden dürfen, muß die einer Anschlußelektrode 8 gegenüberliegende Seite des Resonators von einer Gegenelektrode freigehalten werden.

Wie ohne weiteres aus Fig. 4 zu entnehmen ist, kann der Resonator 1 in vier voneinander verschiedenen, jedoch geometrisch gleichwertigen Drehlagen in die Halteorgane 6 eingesetzt werden. In jeder dieser Positionen ist der Resonator 1 z.B. durch Einbringen von Leitkleber in den von den Halteorganen 6 umfaßten Resonatorrandbereich mit seinen Anregungselektroden 3 elektrisch an jeweils eines der Halteorgane 6 angeschlossen 10.

Auf diese Weise braucht beim Einsetzen des Resonators in die Halteorgane 6 nicht darauf geachtet zu werden, daß ganz bestimmte Eckpunkte von den Halteorganen 6 erfaßt werden. Das Einsetzen des Resonators in die Halteorgane 6 wird dadurch wesentlich vereinfacht.

Die Figuren 1, 2 und 3 zeigen Halteorgane 6, die zur Aufnahme eines rechteckigen Resonators vorgesehen sind. Ein jedes der beiden Halteorgane 6 entsprechend den Figuren 1 bis 3 bildet eine Art Führungsschiene oder Rille, in die der Resonator mit seinen einander gegenüberliegenden Längsseiten eingeschoben werden kann. Die Halteorgane 6 sind dabei so ausgebildet, daß sie für den Resonator 1 nur jeweils in seinen Eckpunkten U-förmige Haltekonturen 9 bilden. Dabei dienen die der Bodenplatte 7 näheren Haltekonturen 9 lediglich der mechanischen Fixierung des Resonators 1.

Sieht man auf jeder Seite des Resonators nur eine einzige zu einem Eckpunkt des Resonators geführte Anschlußelektrode 8 vor(Fig. 1), wobei die beiden Anschlußelektroden 8 zu den mit den freien Enden der Halteorgane 6 korrespondierenden Ecken des Resonators 1 verlaufen müssen, weil nur dort durch Einbringen von Leitkleber eine elektrische Verbindung 10 zwischen den Halteorganen 6 und den Anschlußelektroden 8 ohne Schwierigkeiten bewirkbar ist, so kann der um 180° gedreht in die Halteorgane einsetzbare Resonator, wie Fig. 2 zeigt, in dieser Position nicht angeschlossen werden.

0022559

Versieht man dagegen den Resonator 1 entsprechend Fig. 3
auf jeder seiner beiden großen Oberflächen 2 mit jeweils
zwei Anschlußelektroden 8, die bezüglich der Symmetrieebene 5 spiegelsymmetrisch verlaufen, so kann der Resonator auch um 180° gedreht in die Halteorgane 6 eingesetzt werden, da nun stets Anschlußelektroden 8 zu denjenigen Ecken des Resonators geführt sind, die mit den
von der Bodenplatte 7 entfernteren Haltekonturen 9 der
Halteorgane 6 korrespondieren. Nach dem Einbringen von
Leitkleber an diesen Stellen ist daher der Resonator
stets richtig angeschlossen.

Wie insbesondere die Figuren 10 und 12 zeigen, können
die Anschlußelektroden 8 zwischen dem Rand des Resonators 1 und seinen Anregungselektroden 3 mit einer Einschnürung 11 versehen sein. Diese Einschnürung bewirkt
eine Verminderung der Randempfindlichkeit des Resonators,
wodurch der störende Einfluß von am Rand angreifenden
Halteorganen auf den aktiven Bereich des Resonators
weiter vermindert wird.

3 Patentansprüche
12 Figuren

## Bezugszeichenliste

1  Resonator
2  Große Oberflächen des Resonators 1
3  Anregungselektroden
4  Symmetrieebene
5  Symmetrieebene
6  Halteorgane
7  Bodenplatte
8  Anschlußelektroden
9  Haltekonturen
10  elektrische Verbindung
11  Einschnürung

Patentansprüche

1. Zu Dickenscherungsschwingungen anregbarer, plattenförmiger, piezoelektrischer Resonator mit zwei auf den beiden großen Oberflächen des Resonators angeordneten zentralen Anregungselektroden, die einander gegenüberliegen, und mit wenigstens jeweils einer auf jeder der großen Oberflächen des Resonators zwischen einer Anregungselektrode und dem Resonatorrand vorgesehenen Anschlußelektrode, wobei jeweils eine Anschlußelektrode auf der einen Seite des Resonators zu einer Anschlußelektrode auf der anderen Seite des Resonators bezüglich einer die großen Oberflächen des Resonators halbierenden Symmetrieebene spiegelsymmetrisch verläuft und jeweils der einer Anschlußelektrode gegenüberliegende Resonatorbereich frei von Gegenelektroden ist, sowie mit zwei Anschlußorganen, die den Resonator randseitig im Bereich von auf den beiden Seiten des Resonators vorgesehenen Anschlußelektroden erfassen, d a d u r c h   g e - k e n n z e i c h n e t , daß auf jeder Seite (2) des Resonators (1) neben der zu einem elektrischen Verbindungspunkt (10) zwischen einem Anschlußorgan (6) und einer Anschlußelektrode (8) verlaufenden Anschlußelektrode (8) eine weitere/Anschlußelektrode (8) vorgesehen ist, die (leerlaufende) bezüglich einer Symmetrieebene (5) des Resonators (1), welche die großen Oberflächen des Resonators (1) halbiert, spiegelsymmetrisch zu der jeweils anderen Anschlußelektrode (8) auf derselben Oberflächenseite des Resonators angeordnet ist.

2. Resonator nach Anspruch 1 , d a d u r c h   g e - k e n n z e i c h n e t , daß die Anschlußelektroden (8) bei rechteckigem oder quadratischem Umriß des Resonators (1) zu den vier Ecken des Resonators (1) geführt sind.

3. Resonator nach einem der Ansprüche 1 oder 2, d a -
d u r c h    g e k e n n z e i c h n e t, daß die Anschlußelektroden (8) zwischen den Anregungselektroden (3)
und dem Rand der Resonators (1) mit einer Einschnürung
(11) versehen sind.

FIG 1

FIG 2

FIG 3

FIG 4

FIG 5

FIG 6

FIG 7

FIG 8

FIG 9

FIG 10

FIG 11

FIG 12

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | US - A - 2 434 266 (H.F. FRUTH) <br> * Figuren 1,5; Spalte 3, Zeilen 50-71 * <br><br> -- | 1,2 |
| | PATENTS ABSTRACTS OF JAPAN, Band 2, Nr. 17, 6. Februar 1978, Seite 10954E77 <br> & JP - A - 52 134 347 <br> * Insgesamt * <br><br> -- | 1,2 |
| | GB - A - 730 688 (MARCONI) <br> * Figur 1; Seite 2, Zeile 121 - Seite 3, Zeile 16 * <br><br> -- | 1,2 |
| | GB - A - 548 517 (STANDARD TELE-PHONES AND CABLES) <br> * Figuren 7,8; Seite 5, Zeilen 87-111 * <br><br> -- | 3 |
| D,A | DE - B - 2 737 034 (SIEMENS) <br> * Insgesamt * <br><br> ---- | 1 |

**KLASSIFIKATION DER ANMELDUNG (Int. Cl.)**

H 03 H 9/13

**RECHERCHIERTE SACHGEBIETE (Int. Cl.)**

H 03 H

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort. | Abschlußdatum der Recherche | Prüfer |
|---|---|---|
| Den Haag | 10-10-1980 | COPPIETERS |

EPA form 1503.1   06.78